# EUROPEAN PATENT SPECIFICATION

(11) **EP 3 610 710 B1**
(45) Date of publication and mention of the grant of the patent: **02.08.2023**
(21) Application number: 18722726.9
(22) Date of filing: 11.04.2018
(51) Int. Cl.: H05K 13/00, H05K 13/02, B65G 1/12, B65G 1/137, B65G 1/06, B65G 1/04, H01L 21/67

(54) **DEVICE FOR THE STORAGE OF REELS OF ELECTRONIC COMPONENTS**
VORRICHTUNG ZUR LAGERUNG VON HASPELN ELEKTRONISCHER BAUTEILE
DISPOSITIF DE STOCKAGE DE BOBINES DE COMPOSANTS ÉLECTRONIQUES

(30) Priority: 13.04.2017 IT 201700041473
(43) Date of publication of application: 19.02.2020
(73) Proprietor: I-Tronik S.r.l., 35010 Peraga di Vigonza (PD) (IT)
(72) Inventor: RIZZOLI, Lorenzo, 35010 Peraga di Vigonza (PD) (IT)
(74) Representative: Susanetto, Carlo
(86) International application number: PCT/IB2018/052545
(87) International publication number: WO 2018/189699

(56) References cited:
- EP-A1- 1 344 441
- WO-A1-2014/142374
- WO-A1-2016/103154
- WO-A2-2013/135731
- DE-U1-202004 006 920
- US-A- 5 456 001

## Description

### Technical field

The present invention relates to a device for the storage of reels of electronic components having the features set out in the preamble of the main claim.

### Technological background

The invention is used in particular in industrial processes for manufacturing electronic products, typically printed circuit boards, by means of a surface mounting technique. This technique, which is better known in the field under the acronym SMT (surface mount technology) provides for the different components of a printed circuit board to be applied to a support surface, for example, a printed circuit, by means of welding and/or adhesive bonding.

In a known, commonly used embodiment of this manufacturing process, the SMT technique is carried out by a piece of assembly equipment, to which the different electronic components to be applied to the support are advantageously supplied separately. In particular, each type of electronic component is supplied to the assembly equipment in a form wrapped inside a web of plastics material wound in reels.

The reels of electronic components, in preparation for being used in the production line, are received one by one in respective holders which are in turn stored inside suitable storage devices which are formed by cabinets, inside which the holders which contain the single reels are arranged on one or more shelves.

The rapid production times require that the management of the reels contained in the storage device be accurate and efficient. In fact, it shall be ensured the timely supply of the production line with the reels which contain the electronic components required and the subsequent replenishment thereof inside the storage device.

These operations are often carried out manually by one or more operators who therefore have to provide for finding the reels required inside the cabinet, removing them from the holder and placing them in a container which is transferred to the production line. Subsequently, the operators provide for reintroducing the reels of the missing type inside the cabinet, recording the position thereof.

These operations are obviously costly both in terms of time and in terms of resources.

Therefore, in order to allow quicker and easier management of storage devices with a high number of reels, there have been developed storage devices which are partially automated and provided, for example, with a mechanical manipulator which, in response to instructions from a control unit, moves between the shelves of the cabinet in order to reach the correct position, takes the reel required and transports it to a predefined collection location. Furthermore, the same manipulator is therefore capable of loading a new reel and positioning it at the location indicated by the control unit.

A storage device of this type is described in EP 1928221, wherein there is further provision for the reels taken by the manipulator to be placed one on the other on a single vertically movable carrier which, once the reel collection step has been carried out, is lowered to the collection location.

US 5456001, WO 2013/135731 and EP 1344441 disclose further examples of storage devices according to the prior art.

However, notwithstanding the presence of automatic or semi-automatic storage devices, there remains a need to increase the productivity of the storage device, reducing the collection times of the reels and the loading times thereof.

### Disclosure of the invention

The problem addressed by the present invention is to provide a storage device for reels of electronic components which is structurally and functionally configured to comply with the requirement set out above, at least partially overcoming one or more of the disadvantages encountered in the cited prior art.

This problem is solved by the present invention by means of a storage device realized according to the appended claims.

In a first aspect thereof, the invention is directed to a device for storing reels of electronic components, according to claim 1.

Thanks to this configuration, the storage device according to the invention advantageously allows an increase in the efficiency and the productivity of the reel storage.

In fact, the provision in the support frame of a loading side different from the unloading side allows the reels to be loaded from one side of the storage units and the reels to be unloaded from the other side.

In this manner, the loading and unloading steps of the reels are completely separated from each other so that each of these operations can be carried out independently of the other and, if necessary, also at the same time.

The present invention may have one or more of the preferred features set out below, some of which constitute the subject-matter of the dependent claims.

In a preferred embodiment, the support frame is received inside a box-shaped cabinet, which is generally parallelepipedal, with one or more sides which are closed by respective walls, and which performs a function of protecting and containing the reels which are stored therein.

Preferably, the support frame extends in a main longitudinal direction and the loading and unloading sides are defined by the opposite longitudinal sides of the support frame.

Preferably, there are provided different support frames which are arranged in a superimposed manner in parallel rows.

The storage units are preferably retained and/or supported on the support frame.

In a preferred embodiment, the storage units are configured to receive one reel per unit.

Preferably, from the storage position, the storage unit is pivoted in one direction in order to reach the loading position and in the opposite direction in order to reach the unloading position.

In a preferred embodiment, each storage unit can be pivoted away from and towards the loading position by rotation about a first rotation axis and can be pivoted away from and towards the unloading position by rotation about a second rotation axis, which is different from the first rotation axis.

Preferably, the first and second rotation axes are defined by a first and a second rod of the support frame, respectively, on which the storage units are secured and/or supported.

The support frame can thereby assume a configuration which is particularly simple.

Furthermore, it is preferable for the first and the second support frame rods to extend at the loading and unloading sides, respectively.

In a preferred embodiment, each storage unit comprises a first element which can be pivoted about the first rotation axis and which is configured to abut the reel at the side opposite the loading side. In this manner, when a reel is introduced in the storage unit, the first element of the storage unit is pivoted away from the loading position into the storage position.

Preferably, the first element comprises an appendage which projects towards the loading side.

In this manner, the pivoting of the first element towards the loading position can be obtained simply by means of lowering of the appendage.

In a preferred embodiment, each storage unit further comprises a second element which can be pivoted about the second rotation axis and which is configured to abut the reel at the side opposite the unloading side. In this manner, when the second element of the storage unit is pivoted from the storage position to the unloading position, the reel is unloaded from the storage unit. Preferably, the second element comprises an appendage which projects towards the unloading side.

In this manner, the pivoting of the second element towards the unloading position can be obtained simply by means of lowering of the appendage.

Preferably, the first element comprises at least a first support tooth which extends towards the second element in order to form a base for supporting the reel which is received in the storage unit.

Preferably, the second element also comprises at least a second support tooth which extends towards the first element in order to form a base for supporting the reel which is received in the storage unit.

In a greatly preferred manner, the first tooth and the second tooth are coplanar and adjacent with respect to each other when the storage unit is in a storage position.

In a preferred embodiment of the invention, the storage device further comprises a collection unit for the reels which is associated with the support frame and which is preferably motorized in order to move it between the storage units.

Preferably, the collection unit is movable along the unloading side of the support frames in order to collect a potential unloaded reel from a storage unit and to transport it to a predefined removal location.

In this manner, the unloading operation can be carried out in an automatic manner.

In an alternative embodiment, the loading operation can also be automated by providing a similar loading unit.

Preferably, the collection unit comprises a container which is configured to collect a plurality of reels which are unloaded from respective storage units before being moved towards the removal location.

In this manner, the times for removing the reels and the start thereof towards the production line are reduced.

Preferably, the container is subdivided into a plurality of sectors, each of which is arranged to receive a single reel.

It is further preferable for the container to be positioned in a removable manner in the collection unit.

In this manner, at the end of the collection operation, the container can be completely removed from the collection unit, in the region of the removal location, and directly transferred together with the reels contained therein to the production line, without any need for transferring the reels into another container.

In particular, the collection unit can advantageously be configured to carry the container, in the region of the removal location, to the outer side of the cabinet so as to make it easier to remove it and move it towards the production line.

Preferably, the collection unit is further provided to be moved between a pair of parallel support frames, the unloading sides of which are mutually facing, so as to be able to collect the reels of both the support frames.

In a preferred embodiment of the invention, the collection unit comprises an unloading member which is associated with the container and which can be moved towards the unloading side of the support frame in order to abut the storage unit and to move it from the storage position to the unloading position. In this manner, it is possible for the same collection unit to carry out the unloading of the reel to be removed.

Preferably, the unloading member comprises a guide element in order to guide the falling movement of the reel from the storage unit inside the container.

In this manner, the reels are collected in the container in an orderly manner, typically in a vertical position.

Preferably, the unloading member can be moved along the container so that the reel which is unloaded from the storage unit is collected in a predefined position of the container.

It is thereby possible to collect the reel in a predetermined position of the container, in particular inside one of the empty sectors into which the container is subdivided.

### Brief description of the drawings

The features and advantages of the invention will be better appreciated from the detailed description of a preferred embodiment thereof, illustrated by way of non-limiting example with reference to the single appended drawing, in which:
- Figure 1 is a schematic front view of a device for storing reels of electronic components constructed according to the present invention;
- Figure 2 is a plan view from above of the storage device of Figure 1, without the walls for reasons of clarity;
- Figure 3 is a schematic perspective view of a support frame of the storage device of Figure 1, on which a plurality of storage units are fixed;

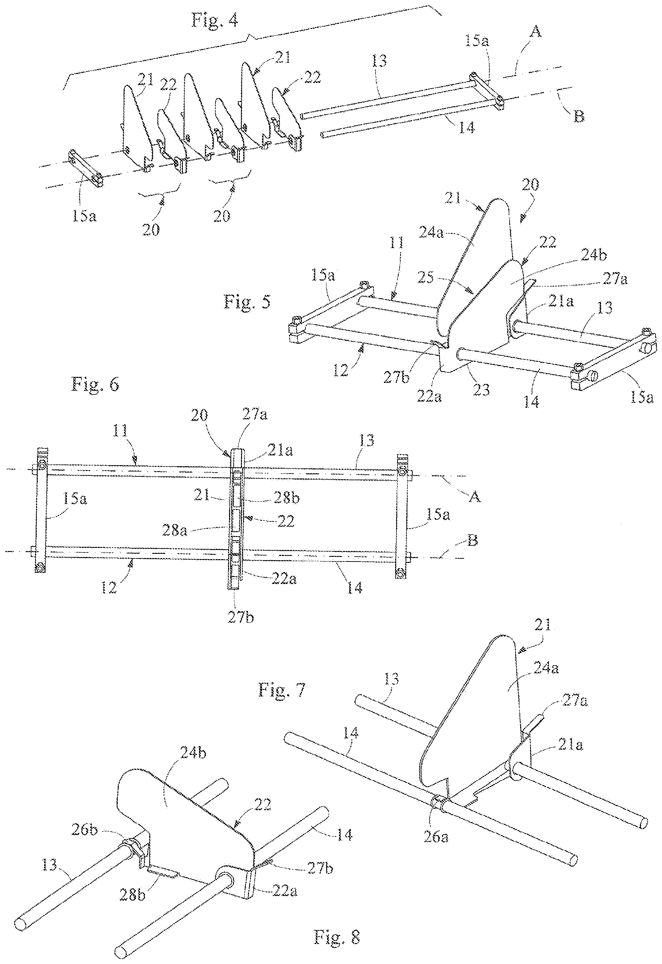

- Figure 4 is an exploded perspective view of the support frame of Figure 3, with a reduced number of storage units, for reasons of clarity;
- Figures 5 and 6 are a perspective view and a plan view from above of one of the storage units of Figure 3 fixed to the support frame, respectively;
- Figure 7 and Figure 8 are perspective views from different angles of respective elements of the storage unit of Figure 5;
- Figure 9 is a schematic perspective view of a collection unit of the storage device of Figure 1;
- Figures 10 to 13 are schematic side views of respective operating steps of the storage device of Figure 1;

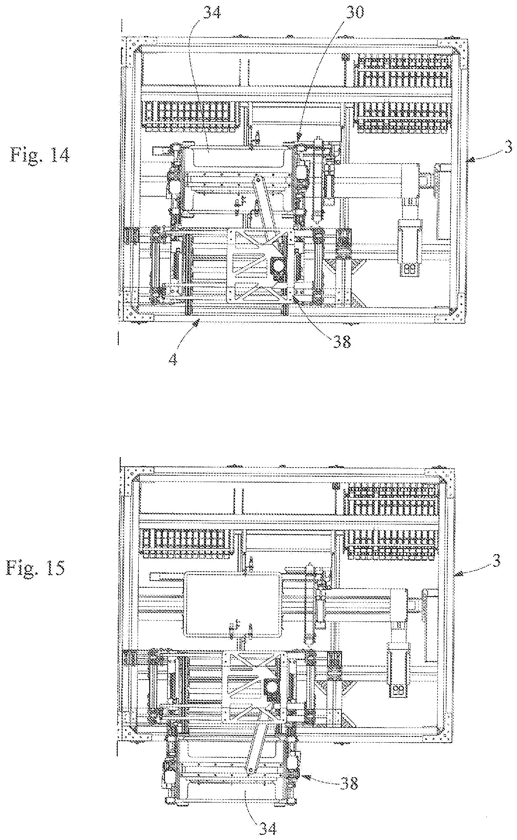

- Figures 14 and 15 are schematic plan views of respective additional operating steps of the storage device of Figure 1.

### Embodiment of the invention

With reference to the appended Figures, there is generally designated 1 a storage device according to the present invention which is specifically configured to store reels 2 of electronic components.

Each reel 2 comprises a web which is wound in a helical manner about itself and in which there are packaged electronic components, such as, for example, microprocessors, resistors, capacitors, inductors, and any other electronic component which is capable of being used in the production of electronic devices by means of SMT technology.

The reels are held inside the storage device 1 in readiness for being transferred to a production line of electronic devices and are from time to time re-introduced inside the storage device 1 with new reels 2 which, for example, are coming from a store.

The storage device 1 comprises a cabinet 3 which is generally parallelepipedal and the sides of which are closed by respective walls.

The cabinet 3 extends mainly in a longitudinal direction X and there are identified thereon a front face 5 and a rear face 6 which are both parallel with the longitudinal direction X.

There are provided along the front face 5 and rear face 6 doors 7 which afford access inside the cabinet 3, as will be better described in the following description.

An opening 4 which constitutes a removal location of the reels 2 is further formed in the front face 5.

A plurality of support frames 10, on which there are provided respective pluralities of storage units 20, are received inside the cabinet 3.

The support frames 10 are arranged on a plurality of levels which are positioned one above the other and which are aligned in two rows which extend parallel with the longitudinal direction X.

Preferably, the first row of support frames 10 is positioned near the front face 5 and the second row of support frames 10 is positioned near the rear face 6 so that there remains defined between the two rows of support frames 10 sufficient space to allow the passage of a collection unit 30 for the reels 2.

Naturally, the support frames 10 can be arranged in different manners inside the cabinet 3.

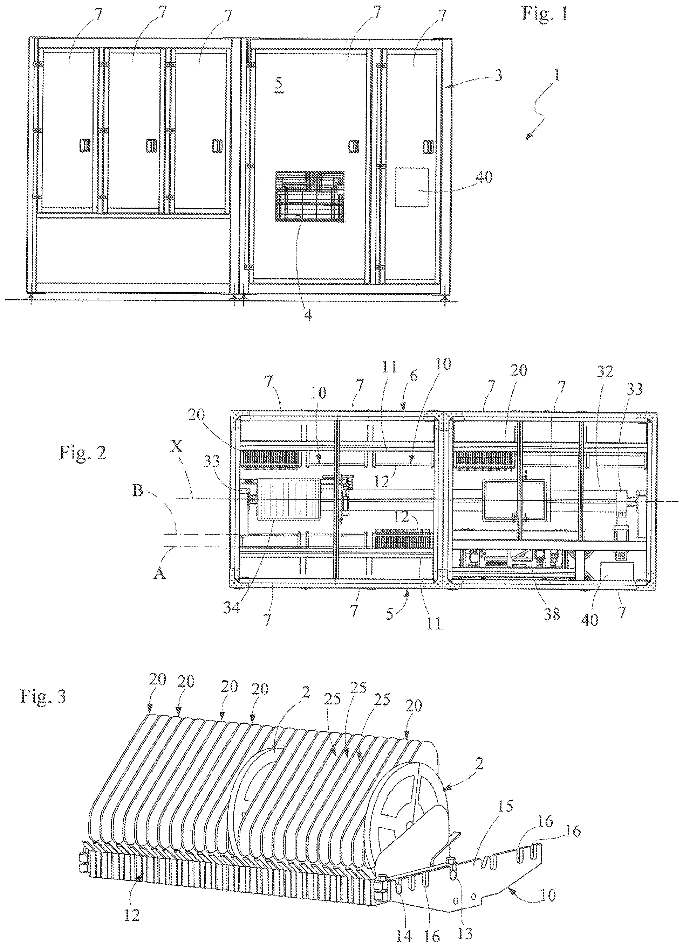

The storage units 20 provided on the support frame 10 are arranged one adjacent to the other in the longitudinal direction X, as illustrated in Figure 3.

There are identified on each support frame 10 a loading side 11 and an unloading side 12 which are different from each other though both are parallel with the longitudinal direction X.

In particular, in the preferred embodiment described here, the loading side 11 is directed towards the faces 5 and 6 of the cabinet 3, while the unloading side 12 is directed towards the centre of the cabinet 3, so that the unloading sides 12 of the two rows of support frames 10 are mutually facing.

In this manner, the loading sides 11 are directly accessible from the outer side of the cabinet 3 through the doors 7 while the unloading sides 12 are directly accessible by the collection unit 30 which moves between the two rows of support frames.

Each support frame 10 comprises a first rod 13 and a second rod 14 which are held parallel with and spaced apart from each other by a pair of clamps 15a. The rods 13 and 14 are supported in the region of the respective longitudinal ends on respective brackets 15, which are in turn fixed to a carrying structure of the storage device 1, preferably so as to extend in the longitudinal direction X.

There are advantageously provided on each bracket 15 different seats 16, which have different spacings from each other and in which there can be received in engagement the ends of the first and second rods 13 and 14. In this manner, the brackets 15 can be used to support pairs of rods 13 and 14 with different interaxial measurements in accordance with the dimensions of the storage units 20 to be supported.

Each storage unit 20 is configured to receive a respective reel 2 in a vertical position without a holder.

Each storage unit comprises a first element 21 and a second element 22 which together form a housing for a reel 2, in which there is defined a support base 23, a pair of opposing sides 24a, 24b which extend in a vertical plane so as to delimit an upper opening 25, through which the reel 2 is loaded or unloaded.

Each storage unit 20 can be pivoted between a storage position, in which the opening is directed upwards so as to retain the reel 2 therein, a loading position, in which the opening 25 is directed towards the loading side 11 so as to make it easier to insert the reel 2 in the storage unit 20, and an unloading position, in which the opening 25 is directed towards the unloading side 12 so as to release the reel 2.

Each storage unit 20 can be pivoted towards and away from the loading position by rotation about a first rotation axis A and can be pivoted away from and towards the unloading position by rotation about a second rotation axis B which is different from the first rotation axis A. Both the rotation axes A and B are parallel with the loading side 11 and unloading side 12.

In construction variants which are not illustrated, there is provision for the storage units 20 to be moved between the above-mentioned positions in different manners, for example, by means of simple translation or rotational translation, or for them to be pivoted about a single rotation axis.

In the preferred embodiment described here, the first rotation axis A is defined by the first rod 13 of the support frame 10 while the second rotation axis B is defined by the second rod 14 of the support frame 10.

In particular, the first element 21 of the storage unit 20 is secured to the first rod 13 with a capacity for limited rotation about the first rod while, similarly, the second element 22 of the storage unit 20 is secured to the second rod 14 with a capacity for limited rotation about the second rod.

The first element 21 comprises a pair of wings 21a, through which the first rod 13 extends and from one of which the side 24a extends. At the opposite side to the first rod 13, the first element 21 comprises a support tongue 26a which is capable of being supported on the second rod 14 when the first element 21 is pivoted into a storage position.

At the opposite side to the support tongue 26a, the first element 21 further comprises an appendage 27a which projects from the loading side 11 so that the lowering thereof brings about the pivoting of the first element 21 from the storage position to the loading position.

Similarly, the second element 22 comprises a pair of wings 22a, through which the second rod 14 extends and from one of which the side 24b extends. At the opposite side to the second rod 14, the second element 22 comprises a support tongue 26b which is capable of being supported on the first rod 13 when the second element 22 is pivoted into a storage position. The side 24b of the second element 22 extends upwards to a lesser extent than the side 24a of the first element 21.

At the opposite side to the support tongue 26b, the second element 22 further comprises an appendage 27b which projects from the unloading side 12 so that the lowering thereof brings about the pivoting of the second element 22 from the storage position to the unloading position.

Preferably, in the storage position, the support tongues 26a and 26b are received between the pairs of wings 21b and 21a of the second element 22 and the first element 21, respectively.

The first element 21 further comprises a first support tooth 28a which extends from the side 24a towards the second element 22 while the second element 22 comprises a second support tooth 28b which extends from the side 24b towards the first element 21.

The first tooth and second tooth 28a, 28b extend from the respective sides 24a and 24b in a staggered position in such a manner that, when both the elements 21 and 22 are in a storage position, they are coplanar and adjacent, together forming the support base 23 of the storage unit 20.

As mentioned above, the storage device 1 comprises a collection unit 30 which can be moved between the rows of the support frames 10 along the respective unloading side 12 and as far as the removal location formed by the opening 4. To this end, the collection unit 30 comprises a motorized carriage 31 which can be moved along a horizontal bar 32 on which in turn it can be moved vertically along a pair of uprights 33. In this manner, the motorised carriage 31 can reach any storage unit 20 which is arranged on different support frames 10.

The collection unit 30 further comprises a container 34 which is provided in order to collect the reels 2 which are unloaded from the storage unit 20 and positioned in a removable manner on the motorised carriage 31 (or engaged therewith) so that it can be readily removed from the collection unit 30 in order to be conveyed to the production line.

The container 34 is advantageously subdivided into a plurality of sectors, each of which is arranged in order to receive a single reel 2 which is released from the storage unit 20.

The collection unit 30 further comprises an unloading member 35 which is associated with the container 34 and which can be moved towards the unloading side 12 of a support frame 10 in order to abut the storage unit 20 which contains the reel 2 to be unloaded and to move it from the storage position to the unloading position.

The unloading member 35 is preferably positioned above the container 34 and comprises a pair of teeth 36 which extend from the opposite sides of the container 34 towards the unloading sides 12 of the two rows of support frames 10, each of them being configured to abut an appendage 27b of a storage unit 20.

The unloading member 35 further comprises a guide element 37 which is formed, for example, by a pair of parallel wings which extend vertically above the container 34 and which is capable of guiding the falling movement of the reel 2 from the storage unit 20 towards the interior of the container 34.

The unloading member 35 is further movable along the container 34 so that the reel 2 which is unloaded from the storage unit 20 is guided while falling by the guide element 37 towards a predefined position of the container 34.

The collection unit 30 further comprises a transfer device 38 which is provided to move the container 34 away from and towards the removal location. In particular, there is provision for the container 34 to be able to be moved as far as the opening 4 so as to make it easy for it to be removed manually by an operator or for it to be moved through the opening outside the cabinet 3.

The transfer device 38 can be produced in different manners and, for example, may comprise grippers and/or a motorized arm which remove(s) the container 34 from the motorized carriage 31 and which convey it towards the opening 4, for example, on a roller type conveyor belt.

The device 1 further comprises a control unit 40 which is programmed to control the movements of the collection unit 30 and preferably also the requirements from the production line about the type and the number of reels to be removed and the positioning of the different reels inside the storage device 1.

The storage device 1 operates as follows.

The loading of the reels 2 in the respective storage units 20 is carried out in a substantially manual manner as a result of an operator who accesses the support frame 10 through the doors 7 of the cabinet 3.

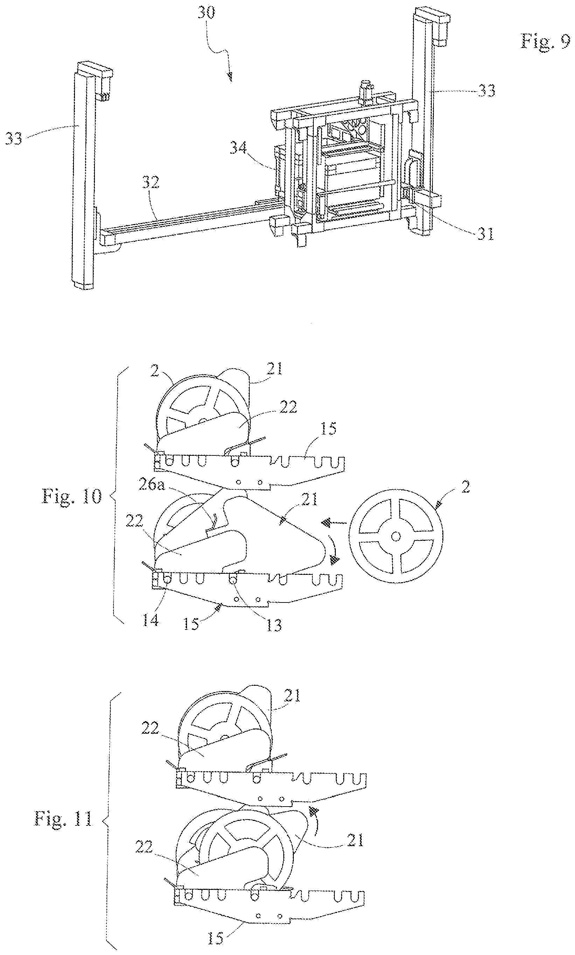

Once the storage unit 20 in which the reel 2 is intended to be inserted has been selected or defined, the operator lowers the appendage 27a of the first element 21 which thus pivots towards the loading side 11, by rotation about the axis A which is defined by the first rod 13 (Figure 10).

The operator then inserts the reel 2 in the storage unit 20, also using the side 24a as a support and guide for the correct insertion of the reel 2 through the opening 25.

The reel 2 during the insertion movement thereof in the storage unit 20 abuts the first tooth 28a and the support tongue 26a by producing the pivoting of the first element 21 into the storage position (Figure 11).

It may be noted that the positioning of the support tongue 26b of the second element 22 on the first rod 13 does not hinder the insertion of the reel 2.

Preferably, the position of the reel 2 inside the specific storage unit 20 is stored in the control unit 40 by taking bar codes present both on the reel and on the storage unit carried out by the operator by means of a suitable bar code reader (not illustrated).

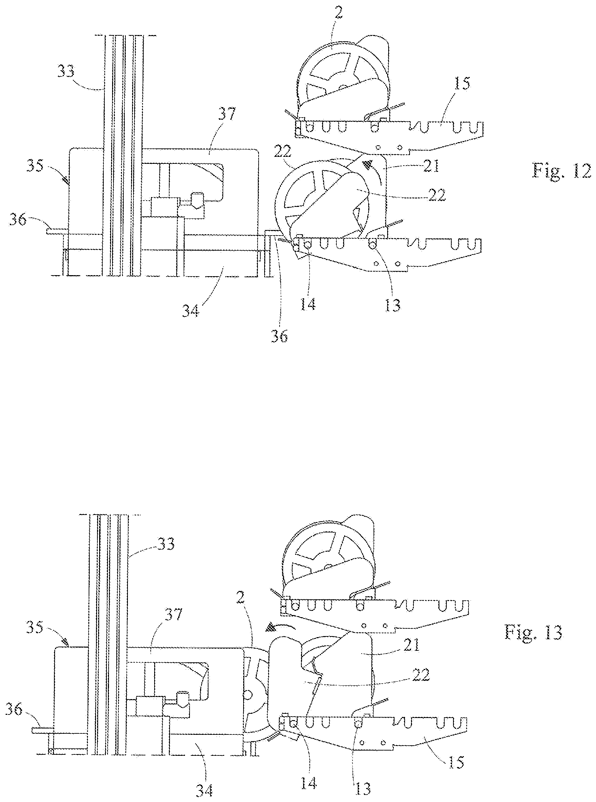

When the production line requests a given number and type of reel 2, the control unit 40, after verifying the presence of these reels and the respective positioning thereof inside the device 1, provides the instructions to the collection unit 30. The motorised carriage 31 on which a container 34 is supported is then moved horizontally (along the bar 32) and/or vertically (along the pair of uprights 33) until being positioned at the side of the storage unit 20 indicated by the control unit 40. At this point, the unloading member 35 is moved away from the container 34 towards the storage unit 20 and lowered so that the tooth 36 abuts the appendage 27b of the storage unit 20, causing the pivoting of the second element 22 from the storage position to the unloading position (Figure 12).

In this manner, the reel 2 is urged by the support tongue 26b and the second tooth 28b towards the unloading side 12 and is unloaded towards the container 34, wherein, in a state suitably guided by the guide element 37, it falls vertically inside a sector of the container 34 (Figure 13).

Thanks to the possibility of movement of the unloading member 35 with respect to the container 34, it will be suitably positioned in such a manner that the reel 2 falls inside an empty sector, without interfering with the sectors which are already occupied by other reels.

When the collection unit 30 has completed the removal of the reels 2 required, or when the container 34 is full, the movable carriage 31 is moved to the height of the opening 4, where the transfer device 38 provides for the container 34 to be removed from the movable carriage 31 and for it to be made available at the opening 4, where applicable also outside the cabinet 3. The container 34 can then be transferred in its present state to the production line together with the load of reels 2 thereof.

A number of variants and modifications which are all included within the scope of protection defined by the content of the appended claims may be applied to the storage device according to the present invention.

The present invention thereby solves the problem set out above with reference to the cited prior art, at the same time providing a number of other advantages, including the fact that the storage device is capable of collecting reels and making them available to the production operation without interfering at all with the loading and reintroduction steps of the reels inside the cabinet.

Furthermore, as a result of the configuration of the storage units and the container with which they are collected, the reels can be stored without any holder, eliminating the times for insertion into the holder and removal from the holder.

Furthermore, as a result of the configuration of the container, different reels can be collected before the whole is carried to the removal location, thereby reducing in a consistent manner the movements of the collection unit inside the cabinet and consequently also the respective operating times.

## Claims

1. A storage device (1) for reels (2) of electronic components comprising:
- a support frame (10); and
- a plurality of storage units (20) which are arranged on the support frame and which are configured to receive at least one of the reels,
wherein there are defined on the support frame:
- an unloading side (12) for accessing the storage units and for unloading the reels from the storage units; and
- a loading side (11), which is different from the unloading side, for accessing the storage units and loading the reels in the storage unit, and
**characterised in that** each storage unit (20) is pivotable between a storage position, in which the reel is retained inside the storage unit, an unloading position, in which the reel is released towards the unloading side, and a loading position, in which it is pivoted towards the loading side (11), in order to make it easier to introduce a reel into the storage unit, and
**in that** in each storage unit (20) there is defined an opening (25) through which the reel is loaded in and unloaded from the storage unit, the opening being directed towards the loading side (11) when the storage unit is pivoted into the loading position and towards the unloading side (12) when the storage unit is pivoted into the unloading position.

2. A device according to claim 1, wherein each storage unit can be pivoted away from and towards the loading position by rotation about a first rotation axis (A) and can be pivoted away from and towards the unloading position by rotation about a second rotation axis (B), which is different from the first rotation axis.

3. A device according to claim 2, wherein the support frame comprises a first rod (13) and a second rod (14) which define the first and second rotation axes (A, B).

4. A device according to any one of the preceding claims, wherein each storage unit comprises a first element (21) which can be pivoted about the first rotation axis (A) and which is configured to abut the reel at the side opposite the loading side (11) so that the introduction of the reel in the storage unit produces the pivoting of the first element away from the loading position into the storage position.

5. A device according to claim 4, wherein the first element comprises an appendage (27a) which projects towards the loading side in order to produce the pivoting of the first element towards the loading position by means of lowering of the appendage.

6. A device according to any one of claims 2 to 5, wherein each storage unit comprises a second element (22) which can be pivoted about the second rotation axis (B) and which is configured to abut the reel at the side opposite the unloading side (12) so that the pivoting of the second element from the storage position to the unloading position brings about the unloading of the reel from the storage unit.

7. A device according to claim 6, wherein the second element comprises an appendage (27b) which projects towards the unloading side (12) in order to produce the pivoting of the second element towards the unloading position by means of lowering of the appendage.

8. A device according to claim 6 or 7, wherein the first element (21) comprises at least a first support tooth (28a) which extends towards the second element (22) in order to form a base (23) for supporting the reel when it is received in the storage unit, and wherein the second element preferably comprises at least a second support tooth (28b) which extends towards the first element in order to form a base (23) for supporting the reel when it is received in the storage unit, and wherein the first tooth (28a) and the second tooth (28b) are preferably coplanar and adjacent with respect to each other when the storage unit is in a storage position.

9. A device according to any one of the preceding claims, wherein there is associated with the support frame a collection unit (30) which can be moved along the unloading side and which comprises a container (34) which is provided to collect a plurality of reels (2) which are unloaded from the storage unit (20) and to transport them to a removal location (4) which is defined in the storage device.

10. A device according to claim 9, wherein the container is subdivided into a plurality of sectors, each of which being arranged to receive a single reel.

11. A device according to claim 9 or 10, wherein the collection unit comprises an unloading member (35) which is associated with the container (34) and which can be moved towards the unloading side (12) in order to abut the storage unit and to move it from the storage position to the unloading position.

12. A device according to claim 11, wherein the unloading member (35) comprises a guide element (37) in order to guide the falling movement of the reel (2) from the storage unit to the container (34).

13. A device according to claim 11 or 12, wherein the unloading member (35) can be moved along the container so that the reel which is unloaded from the storage unit is collected in a predefined position of the container (34).

## Patentansprüche

1. Vorrichtung zur Lagerung von Haspeln mit elektronischen Bauteilen, umfassend:
- einen Tragrahmen (10), und
- eine Vielzahl von Lagereinheiten (20), die am Tragrahmen angeordnet sind und die zur Aufnahme zumindest einer der Haspeln konfiguriert sind,
wobei auf dem Tragahmen definiert sind:
- eine Entladeseite (12) für den Zugang zu den Lagereinheiten und zum Entladen der Haspeln aus den Lagereinheiten; und
- eine Beladeseite (11), die sich von der Entladeseite unterscheidet, für den Zugang zu den Lagereinheiten und zum Beladen der Haspeln in die Lagereinheit, und
**dadurch gekennzeichnet, dass** jede Lagereinheit (20) zwischen einer Lagerposition, in der die Haspel im Inneren der Lagereinheit gehalten wird, einer Entladeposition, in der die Haspel in Richtung der Entladeseite freigegeben wird, und einer Ladeposition, in der diese in Richtung der Beladeseite (11) schwenkbar ist, um das Einführen einer Haspel in die Lagereinheit zu erleichtern, und
dass in jeder Lagereinheit (20) eine Öffnung (25) definiert ist, durch welche die Haspel in die Lagereinheit eingeladen und aus dieser entladen wird, wobei die Öffnung in Richtung der Ladeseite (11), wenn die Lagereinheit in die Ladeposition geschwenkt ist, und in Richtung der Entladeseite (12) gerichtet ist, wenn die Lagereinheit in die Entladeposition geschwenkt ist.

2. Vorrichtung nach Anspruch 1, wobei jede Lagereinheit durch Drehung um eine erste Drehachse (A) von der Beladeposition weg und in deren Richtung schwenkbar ist, und durch Drehung um eine zweite Drehachse (B), die sich von der ersten Drehachse unterscheidet, von der Entladeposition weg und in deren Richtung schwenkbar ist.

3. Vorrichtung nach Anspruch 2, wobei der Tragrahmen eine erste Stange (13) und eine zweite Stange (14) umfasst, welche die ersten und zweiten Drehachsen (A, B) definieren.

4. Vorrichtung nach einem der vorhergehenden Ansprüche, wobei jede Speichereinheit ein erstes Element (21) umfasst, das um die erste Drehachse (A) schwenkbar ist und zum Anliegen an der der Haspel gegenüberliegenden Seite der Beladeseite (11) konfiguriert ist, sodass das Einführen der Haspel in die Lagereinheit das Schwenken des ersten Elements von der Beladeposition weg in die Lagerposition bewirkt.

5. Vorrichtung nach Anspruch 4, wobei das erste Element einen Fortsatz (27a) umfasst, der in Richtung der Beladeseite vorragt, um durch Absenken des Fortsatzes das Schwenken des ersten Elements in Richtung der Beladeposition zu bewirken.

6. Vorrichtung nach einem der Ansprüche 2 bis 5, wobei jede Lagereinheit ein zweites Element (22) umfasst, das um die zweite Drehachse (B) schwenkbar ist und zum Anliegen an der der Haspel gegenüberliegenden Seite der Entladeseite (12) konfiguriert ist, sodass das Schwenken des zweiten Elements von der Ladeposition in die Entladeposition das Entladen der Haspel aus der Lagereinheit bewirkt.

7. Vorrichtung nach Anspruch 6, wobei das zweite Element einen Fortsatz (27b) umfasst, der in Richtung der Entladeseite (12) vorragt, um durch Absenken des Fortsatzes das Schwenken des zweiten Elements in die Entladeposition zu bewirken.

8. Vorrichtung nach Anspruch 6 oder 7, wobei das erste Element (21) zumindest einen ersten Stützzahn (28a) umfasst, der sich in Richtung des zweiten Elements (22) erstreckt, um eine Basis (23) zum Abstützen der Haspel zu bilden, wenn diese in der Lagereinheit aufgenommen ist, und wobei das zweite Element vorzugsweise zumindest einen zweiten Stützzahn (28b) umfasst, der sich in Richtung des ersten Elements erstreckt, um eine Basis (23) zum Abstützen der Haspel zu bilden, wenn diese in der Lagereinheit aufgenommen ist, und wobei der erste Zahn (28a) und der zweite Zahn (28b) vorzugsweise koplanar sind und aneinander angrenzen, wenn sich die Lagereinheit in einer Lagerposition befindet.

9. Vorrichtung nach einem der vorhergehenden Ansprüche, wobei dem Tragrahmen eine Sammeleinheit (30) zugeordnet ist, die entlang der Entladeseite bewegbar ist und die einen Behälter (34) umfasst, der zum Sammeln einer Vielzahl von Haspeln (2), die aus der Lagereinheit (20) entladen werden, und zum Transportieren zu einem Entnahmeort (4) vorgesehen ist, der in der Lagervorrichtung definiert ist.

10. Vorrichtung nach Anspruch 9, wobei der Behälter in eine Vielzahl von Sektoren unterteilt ist, von denen jeder zur Aufnahme einer einzelnen Haspel eingerichtet ist.

11. Vorrichtung nach Anspruch 9 oder 10, wobei die Sammeleinheit ein Entladeelement (35) umfasst, das dem Behälter (34) zugeordnet ist und das in Richtung der Entladeseite (12 bewegbar ist, um an der Lagereinheit anzuliegen und diesen von der Lagerposition in die Entladeposition zu bewegen.

12. Vorrichtung nach Anspruch 11, wobei das Entladeelement (35) ein Führungselement (37) umfasst, um die Fallbewegung der Haspel (2) von der Lagereinheit zum Behälter (34) zu führen.

13. Vorrichtung nach Anspruch 11 oder 12, wobei das Entladeelement (35) entlang des Behälters bewegbar ist, sodass die Haspel, die aus der Lagereinheit entladen wird, in einer vordefinierten Position des Behälters (34) gesammelt wird.

## Revendications

1. Dispositif de stockage (1) pour des bobines (2) de composants électroniques comprenant :
- un cadre de support (10) ; et
- une pluralité d'unités de stockage (20) qui sont agencées sur le cadre de support et qui sont configurées pour recevoir au moins une des bobines,
dans lequel sont définis sur le cadre de support :
- un côté de déchargement (12) pour accéder aux unités de stockage et pour décharger les bobines des unités de stockage ; et
- un côté de chargement (11), qui est différent du côté de déchargement, pour accéder aux unités de stockage et charger les bobines dans l'unité de stockage, et
**caractérisé en ce que** chaque unité de stockage (20) peut pivoter entre une position de stockage, dans laquelle la bobine est retenue à l'intérieur de l'unité de stockage, une position de déchargement, dans laquelle la bobine est libérée en direction du côté de déchargement, et une position de chargement, dans laquelle elle est pivotée en direction du côté de chargement (11), afin de faciliter l'introduction d'une bobine dans l'unité de stockage, et
**en ce que** dans chaque unité de stockage (20) est définie une ouverture (25) à travers laquelle la bobine est chargée dans et déchargée de l'unité de stockage, l'ouverture étant dirigée en direction du côté de chargement (11) lorsque l'unité de stockage est pivotée dans la direction de chargement et en direction du côté de déchargement (12) lorsque l'unité de stockage est pivotée dans la position de déchargement.

2. Dispositif selon la revendication 1, dans lequel chaque unité de stockage peut être pivotée depuis et vers la position de chargement par rotation autour d'un premier axe de rotation (A) et peut être pivotée depuis et vers la position de déchargement par rotation autour d'un deuxième axe de rotation (B), qui est différent du premier axe de rotation.

3. Dispositif selon la revendication 2, dans lequel le cadre de support comprend une première tige (13) et une deuxième tige (14) qui définissent les premier et deuxième axes de rotation (A, B).

4. Dispositif selon l'une quelconque des revendications précédentes, dans lequel chaque unité de stockage comprend un premier élément (21) qui peut être pivoté autour du premier axe de rotation (A) et qui est configuré pour venir buter contre la bobine au niveau du côté opposé au côté de chargement (11) de sorte que l'introduction de la bobine dans l'unité de stockage produise le pivotement du premier élément depuis la position de chargement dans la position de stockage.

5. Dispositif selon la revendication 4, dans lequel le premier élément comprend un appendice (27a) qui fait saillie en direction du côté de chargement afin de produire le pivotement du premier élément en direction de la position de chargement au moyen d'un abaissement de l'appendice.

6. Dispositif selon l'une quelconque des revendications 2 à 5, dans lequel chaque unité de stockage comprend un deuxième élément (22) qui peut être pivoté autour du deuxième axe de rotation (B) et qui est configuré pour venir buter contre la bobine au niveau du côté opposé au côté de déchargement (12) de sorte que le pivotement du deuxième élément de la position de stockage à la position de déchargement provoque le déchargement de la bobine à partir de l'unité de stockage.

7. Dispositif selon la revendication 6, dans lequel le deuxième élément comprend un appendice (27b) qui fait saillie en direction du côté de déchargement (12) afin de produire le pivotement du deuxième élément en direction de la position de déchargement au moyen d'un abaissement de l'appendice.

8. Dispositif selon la revendication 6 ou 7, dans lequel le premier élément (21) comprend au moins une première dent de support (28a) qui s'étend en direction du deuxième élément (22) afin de former une base (23) pour supporter la bobine lorsqu'elle est reçue dans l'unité de stockage, et dans lequel le deuxième élément comprend de préférence au moins une deuxième dent de support (28b) qui s'étend en direction du premier élément afin de former une base (23) pour supporter la bobine lorsqu'elle est reçue dans l'unité de stockage, et dans lequel la première dent (28a) et la deuxième dent (28b) sont de préférence coplanaires et adjacentes l'une par rapport à l'autre lorsque l'unité de stockage est dans une position de stockage.

9. Dispositif selon l'une quelconque des revendications précédentes, dans lequel une unité de collecte (30) est associée au cadre de support, l'unité de collecte pouvant être déplacée le long du côté de déchargement et comprenant un contenant (34) qui est fourni pour collecter une pluralité de bobines (2) qui sont déchargées à partir de l'unité de stockage (20) et pour transporter celles-ci vers un emplacement d'élimination (4) qui est défini dans le dispositif de stockage.

10. Dispositif selon la revendication 9, dans lequel le contenant est sous-divisé en une pluralité de secteurs, donc chacun est agencé pour recevoir une unique bobine.

11. Dispositif selon la revendication 9 ou 10, dans lequel l'unité de collecte comprend un élément de déchargement (35) qui est associé au contenant (34) et qui peut être déplacé en direction du côté de déchargement (12) afin de venir buter contre l'unité de stockage et pour déplacer celle-ci de la position de stockage à la position de déchargement.

12. Dispositif selon la revendication 11, dans lequel l'élément de déchargement (35) comprend un élément de guidage (37) afin de guider le mouvement de chute de la bobine (2) de l'unité de stockage au contenant (34).

13. Dispositif selon la revendication 11 ou 12, dans lequel l'élément de déchargement (35) peut être déplacé le long du contenant de sorte que la bobine qui est déchargée à partir de l'unité de stockage est collectée dans une position prédéfinie du contenant (34).
